Europäisches Patentamt

European Patent Office

Office européen des brevets

(19)

(11) **EP 1 166 134 B1**

(12) **FASCICULE DE BREVET EUROPEEN**

(45) Date de publication et mention
de la délivrance du brevet:
**14.05.2003 Bulletin 2003/20**

(21) Numéro de dépôt: **00910984.4**

(22) Date de dépôt: **17.03.2000**

(51) Int Cl.⁷: **G01R 19/18**

(86) Numéro de dépôt international:
**PCT/FR00/00664**

(87) Numéro de publication internationale:
**WO 00/057197 (28.09.2000 Gazette 2000/39)**

(54) **PROCEDE DE SURVEILLANCE DE LA CIRCULATION D'UN COURANT SENSIBLEMENT CONTINU DANS UNE CHARGE**

**VERFAHREN ZUR ÜBERWACHUNG DES FLIESSENS EINES IM WESENTLICHEN GLEICHFÖRMIGEN STROMES IN EINER LAST**

**METHOD FOR MONITORING A SUBSTANTIALLY DIRECT CURRENT FLOW IN A LOAD**

(84) Etats contractants désignés:
**DE FR GB**

(30) Priorité: **19.03.1999 FR 9903464**

(43) Date de publication de la demande:
**02.01.2002 Bulletin 2002/01**

(73) Titulaire: **THALES AVIONICS S.A.**
**78140 Vélizy-Villacoublay (FR)**

(72) Inventeur: **CHOISNET, Joel**
**Thomson-CSF Prop. Intellectuelle**
**F-94117 Arcueil Cedex (FR)**

(74) Mandataire: **Guérin, Michel**
**THALES Intellectual Property,**
**13, Avenue du Président Salvador Allende**
**94117 Arcueil Cédex (FR)**

(56) Documents cités:
**DE-A- 2 407 152**

- **PATENT ABSTRACTS OF JAPAN vol. 1996, no. 03, 29 mars 1996 (1996-03-29) -& JP 07 306232 A (KOKUSAI DENSHIN DENWA CO LTD ;OTHERS: 01), 21 novembre 1995 (1995-11-21)**
- **PATENT ABSTRACTS OF JAPAN vol. 1995, no. 07, 31 août 1995 (1995-08-31) & JP 07 110347 A (NEC CORP), 25 avril 1995 (1995-04-25)**

**Description**

L'invention se rapporte à un dispositif de surveillance de la circulation d'un courant sensiblement continu dans une charge et à un procédé pour la mise en oeuvre de ce dispositif.

Dans certaines applications, par exemple aéronautique, on surveille la circulation du courant dans une charge afin de déclencher une alarme en cas d'absence de courant.

Lorsque la charge est alimentée par une source de tension continue, il est possible de placer sur un des fils d'alimentation de la charge un moyen pour détecter la circulation d'un courant dans le fil d'alimentation de la charge. Si ce moyen indique l'absence de courant, on peut en déduire que l'alimentation est absente ou que la charge présente un défaut de fonctionnement. Dans la pratique, les moyens connus pour détecter la circulation d'un courant continu, comme par exemple un détecteur à effet Hall, nécessitent un amplificateur pour traiter le signal issu du détecteur. Un tel amplificateur peut lui aussi présenter une anomalie et par exemple, se bloquer dans un état indiquant en permanence la circulation d'un courant dans la charge indépendamment de l'existence réelle d'un courant circulant dans la charge. On peut surveiller le dispositif de surveillance, en prévoyant un second dispositif de surveillance pour surveiller le premier, ce qui complique la réalisation globale du système comportant l'alimentation en courant continu, la charge et les deux dispositifs de surveillance.

L'invention a pour but de pallier ce problème, en proposant un dispositif de surveillance qui, même en cas de panne du dispositif, indiquera une anomalie et ne pourra pas, comme dans le cas de la solution précédemment envisagée, indiquer un bon fonctionnement lorsque le courant ne circule pas dans la charge.

Pour atteindre ce but, l'invention a pour objet un dispositif de surveillance de la circulation d'un courant sensiblement continu dans une charge, caractérisé en ce qu'il comporte, connecté en série avec la charge, des premiers moyens pour détecter la présence d'un courant alternatif, et en ce qu'il comporte en outre des seconds moyens pour interrompre le courant circulant dans les premiers moyens tout en maintenant le courant sensiblement continu dans la charge.

L'invention a également pour objet un procédé de surveillance de la circulation d'un courant sensiblement continu dans une charge, caractérisé en ce qu'il utilise un dispositif comportant, connecté en série avec la charge, des premiers moyens pour détecter la présence d'un courant alternatif, des seconds moyens pour interrompre le courant circulant dans les premiers moyens ainsi que des troisièmes moyens susceptibles de court-circuiter les premiers et seconds moyens, et en ce que le procédé enchaîne de façon cyclique les temps de fonctionnement suivants tant que la charge est alimentée :

- pendant le premier temps le courant circule uniquement dans les seconds moyens ;
- pendant le deuxième temps le courant circule à la fois dans les seconds moyens et dans les troisièmes moyens ;
- pendant le troisième temps le courant circule uniquement dans les troisièmes moyens;
- le quatrième temps est identique au deuxième temps.

Dans l'art antérieur plusieurs documents tels que : PATENT ABSTRACTS OF JAPAN vol. 1996 n° 03, 29 mars 1996 (1996-03-29)-& JP 07 306232 A (KOKUSAI DENSHIN DENWA CO LTD ; OTHERS : 01), DE 24 07 152 A, PATENT ABSTRACTS OF JAPAN vol. 1995, n° 07, 31 août 1995 (1995-08-31) & JP 07 110347 A (NEC CORP) décrivent un fonctionnement dans lequel seuls les premier et troisième temps sont présents.

L'existence des deuxièmes et quatrième temps permet d'éviter que le courant ne soit interrompu dans la charge. En effet, l'ouverture et la fermeture d'interrupteurs électroniques pour interrompre ou pour faire circuler le courant dans les seconds et troisièmes moyens ne sont jamais parfaites ce qui en l'absence des deuxièmes et quatrième temps risquerait d'entraîner des perturbations électromagnétiques dues à des fluctuations dans la circulation du courant.

De façon avantageuse, l'invention a pour objet un dispositif de surveillance de la circulation d'un courant sensiblement continu dans une charge, caractérisé en ce qu'il comporte au moins un premier interrupteur électronique connecté en série avec la charge et avec des premiers moyens pour détecter la présence d'un courant alternatif, le premier interrupteur électronique étant commandé de façon à établir le courant alternatif dans les premiers moyens, et en ce qu'il comporte en outre des seconds moyens pour maintenir le courant sensiblement continu dans la charge.

Un procédé de mise en oeuvre de ce dispositif consiste à ouvrir et fermer de façon cyclique l'interrupteur électronique tout en rendant opérable et non opérable également de façon cyclique les seconds moyens pour maintenir le courant sensiblement continu dans la charge et pour ne laisser passer que périodiquement le courant circulant dans la charge à travers les seconds moyens.

Selon un premier mode de réalisation, le procédé selon l'invention est caractérisé en ce que les seconds moyens comportent un premier interrupteur électronique, en ce que les troisièmes moyens comportent un second interrupteur électronique connecté en parallèle d'un ensemble formé par le premier interrupteur électronique et les premiers moyens pour détecter la présence d'un courant alternatif, et en ce que le procédé enchaîne de façon cyclique les temps de fonctionnement suivants tant que la charge est alimentée :

- pendant le premier temps le premier interrupteur électronique est fermé et le second interrupteur électronique est ouvert ;

- pendant le deuxième temps les premier et second interrupteurs électroniques sont tous deux fermés ;
- pendant le troisième temps le premier interrupteur électronique est ouvert et le second interrupteur électronique est fermé;
- le quatrième temps est identique au deuxième temps.

Selon un second mode de réalisation, le procédé selon l'invention est caractérisé en ce que les seconds et troisièmes moyens comportent quatre interrupteurs électroniques, en ce que le premier interrupteur et le quatrième interrupteur sont tous deux connectés en série avec la charge, en ce que le troisième interrupteur et le deuxième interrupteur sont tous deux connectés en série et forment un ensemble connecté en parallèle des premiers et quatrième interrupteurs, en ce que le point commun des premier et quatrième interrupteurs est connecté au point commun des troisième et deuxième interrupteurs, et en ce que les premiers moyens pour détecter la présence d'un courant alternatif surveillent le courant circulant entre les deux points communs, et en ce que le procédé enchaîne de façon cyclique les temps de fonctionnement suivants tant que la charge est alimentée :

- pendant le premier temps les premier et deuxième interrupteurs électroniques sont conducteurs et les troisième et quatrième interrupteurs électroniques sont non conducteurs ;
- pendant le deuxième temps les quatre interrupteurs électroniques sont conducteurs ;
- pendant le troisième temps les premier et deuxième interrupteurs électroniques sont non conducteurs et les troisième et quatrième interrupteurs électroniques sont conducteurs ;
- pendant le quatrième temps les quatre interrupteurs électroniques sont conducteurs.

L'invention sera mieux comprise et d'autres avantages apparaîtront à la lecture de la description détaillée de plusieurs modes de réalisation illustrés par le dessin joint dans lequel :

- la figure 1 représente un premier mode de réalisation dans lequel deux interrupteurs électroniques sont placés en série avec la charge ;
- la figure 2 représente un second mode de réalisation dans lequel quatre interrupteurs électroniques sont placés en série avec la charge ;
- la figure 3 représente un schéma détaillé du mode de réalisation décrit à la figure 2 ;
- la figure 4 représente, sous forme de chronogramme, le fonctionnement du dispositif représenté à la figure 3.

Pour plus de commodités dans la description les mêmes repères topologiques représentent les mêmes éléments dans les différentes figures.

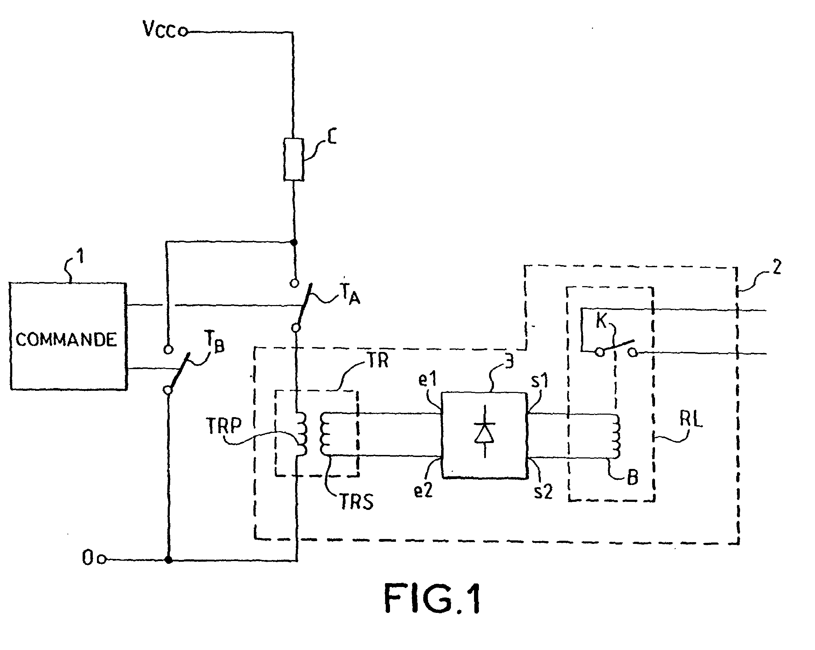

A la figure 1, une charge C est alimentée par une source de tension continue. La source de tension continue comporte deux bornes : 0 pour la masse et VCC pour le point tension positive.

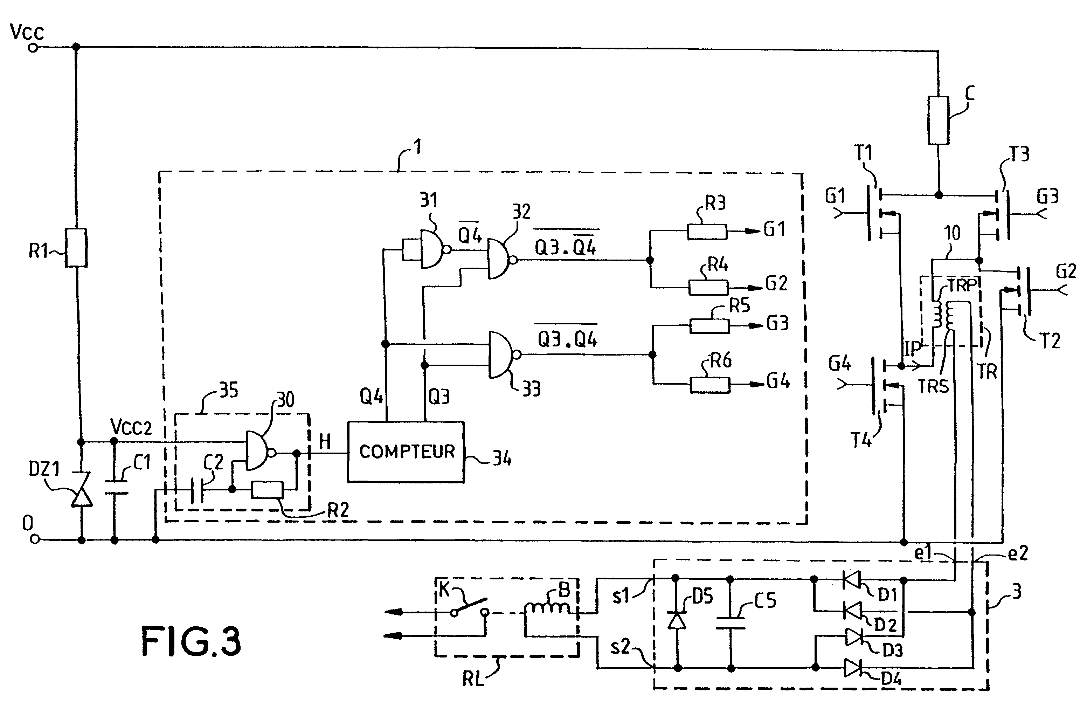

Entre les deux bornes 0 et VCC, en série avec la charge C, on a placé deux interrupteurs électronique TA et TB en parallèle. Pour ouvrir et fermer les interrupteurs électroniques TA et TB, le dispositif comporte des moyens de commande 1 des interrupteurs électroniques TA et TB. Pour réaliser les moyens de commande 1, on pourra par exemple adapter le principe décrit ultérieurement plus en détail au moyen de la figure 3.

Le dispositif comporte en outre des moyens 2 pour détecter la présence d'un courant alternatif circulant dans l'interrupteur électronique TA. Ces moyens 2 comportent, par exemple, un transformateur de courant TR. Le transformateur de courant TR comporte un enroulement primaire TRP et un enroulement secondaire TRS. L'enroulement primaire TRP du transformateur de courant TR est connecté en série entre l'interrupteur électronique TA et la borne 0 de la source de tension continue. Il est bien entendu que l'ordre dans lequel la charge C, l'interrupteur TA et l'enroulement primaire TRP sont raccordés en série, est indifférent pour la mise en oeuvre de l'invention. Les moyens pour détecter la présence du courant alternatif comportent en outre un redresseur 3. Le redresseur 3 comporte deux points d'entrée e1 et e2 ainsi que deux points de sortie s1 et s2. Lorsqu'on alimente le redresseur 3, entre ses deux points d'entrée e1 et e2, par un courant alternatif, on dispose alors d'un courant sensiblement continu circulant dans un composant électrique raccordé entre les deux points de sortie s1 et s2. L'enroulement secondaire TRS du transformateur du courant TR est raccordé aux deux points d'entrée e1 et e2 du redresseur 3. Les moyens 2 pour détecter la présence du courant alternatif comporte en outre un relais RL. Le relais RL comporte une bobine B commandant l'ouverture ou la fermeture d'un contact K. La bobine B est alimentée entre les deux points de sortie s1 et s2 du redresseur 3. Les deux connexions du contact K sont reliées vers l'extérieur du dispositif.

Lorsque l'interrupteur électronique TA est ouvert et fermé alternativement, un courant alternatif y circule. Ce courant alternatif circule également dans l'enroulement primaire TRP du transformateur du courant TR. Ce courant induit dans l'enroulement secondaire TRS du transformateur de courant TR un autre courant alternatif. Cet autre courant alternatif est redressé au moyen du redresseur 3. Entre les points de sortie s1 et s2 du redresseur 3 circule alors un courant sensiblement continu dans la bobine B. Lorsqu'un tel courant circule dans la bobine B le contact K change d'état. On choisit le relais RL monostable par exemple normalement ouvert. Ainsi lorsqu'un courant alternatif circule dans l'enroulement primaire TRP, le contact K est fermé. En revanche lorsque aucun courant alternatif ne traverse l'enroulement primaire TRP, le contact K reste ouvert. Et on peut utiliser l'ouverture de ce contact K pour déclencher une alarme extérieure au dispositif.

Le dispositif tel que décrit précédemment permet de détecter une anomalie dans l'un des composants du dispositif. Le relais K ne sera pas activé, par exemple, dans les cas suivants

- absence de tension continue entre les bornes 0 et VCC de la source de tension continue ;
- coupure de la liaison comprise entre les bornes 0 et VCC et comportant la charge C, l'interrupteur électronique TA et l'enroulement primaire TRP ;
- défaut dans le fonctionnement des moyens de commande 1 des interrupteurs électroniques TA et TB ;
- défaut de fonctionnement du redresseur 3 ;
- coupure dans une des liaisons reliant l'enroulement secondaire TRS le redresseur 3 et la bobine B du relais RL.

On constate qu'aucun défaut de fonctionnement cité précédemment ne peut entraîner l'activation du contact K. Il n'est donc pas nécessaire de surveiller le dispositif de surveillance lui-même.

Le mode de réalisation représenté figure 1 permet de moduler la puissance dissipée dans la charge, par exemple en faisant varier le rapport cyclique d'ouverture et de fermeture de l'interrupteur électronique TA tout en laissant l'interrupteur électronique TB ouvert. En revanche ce mode de réalisation peut entraîner des perturbations électromagnétiques dues à l'ouverture et à la fermeture fréquente de l'interrupteur électronique TA.

Avantageusement, le mode de réalisation représenté figure 1 fonctionne de façon à ce que le courant circulant dans la charge C reste sensiblement continu. Pour ce faire, on peut enchaîner quatre temps de fonctionnement :

- pendant le premier temps ① l'interrupteur électronique TA est fermé et l'interrupteur électronique TB est ouvert et un courant circule dans l'enroulement primaire TRP ;
- pendant le deuxième temps ② les interrupteurs électroniques TA et TB sont tous deux fermés et aucun courant ne circule dans l'enroulement primaire TRP;
- pendant le troisième temps ③ l'interrupteur électronique TA est ouvert et l'interrupteur électronique TB est fermé et aucun courant ne circule dans l'enroulement primaire TRP;
- le quatrième temps ④ est identique au deuxième temps ②. Ensuite on répète les quatre temps de fonctionnement décrits précédemment tant que la charge C est alimentée par la source de tension continue.

Ainsi le courant circulant dans l'enroulement primaire TRP varie entre une valeur nulle et la valeur du courant continu circulant dans la charge C.

Dans le mode de réalisation représenté figure 1, il est possible de se passer de l'interrupteur TA en adaptant les impédances relatives de l'enroulement primaire TRP du transformateur de courant TR et de l'interrupteur électronique TB de façon à faire varier le courant circulant dans l'enroulement primaire TRP entre le moment où l'interrupteur électronique TB est ouvert et le moment où l'interrupteur électronique TB est fermé. Cette variante est économique. Néanmoins elle provoque des variations de courant circulant dans la charge C entraînant ici encore des perturbations électromagnétiques.

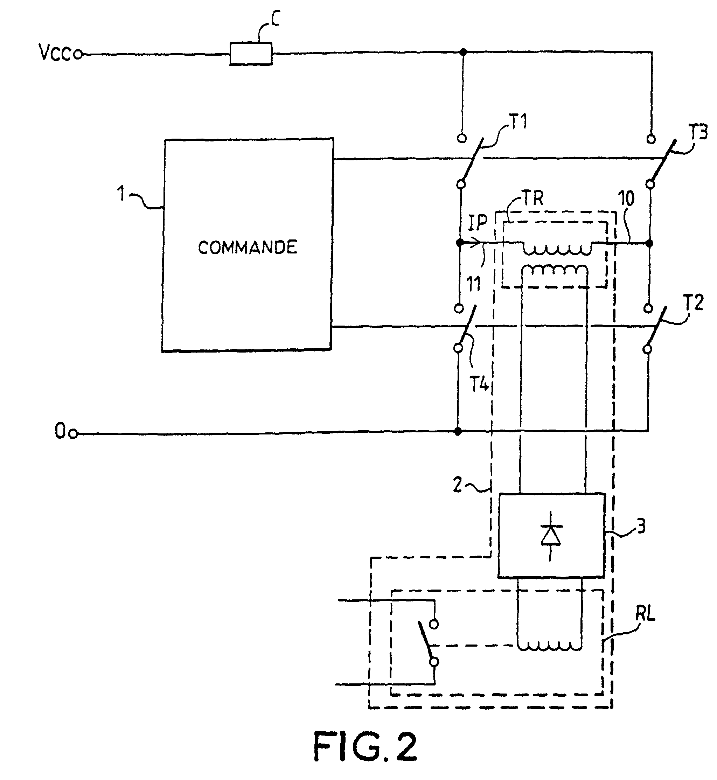

La figure 2 représente un mode de fonctionnement où le courant circulant dans l'enroulement primaire TRP peut varier avec une amplitude double de celle du courant circulant dans l'enroulement primaire TRP du dispositif décrit à l'aide de la figure 1, ce qui permet de faciliter sa détection.

Comme à la figure 1, le dispositif représenté figure 2 comporte charge C alimentée entre les deux bornes VCC et 0 d'une source de tension continue. En revanche le dispositif représenté figure 2 comporte quatre interrupteurs électroniques T1, T2, T3 et T4. Le premier interrupteur T1 et le quatrième interrupteur T4 sont tous deux connectés en série entre la charge C et une des bornes de la source de tension continue, par exemple, la borne 0. Le troisième interrupteur T3 et le deuxième interrupteur T2 sont tous deux connectés en série et l'ensemble formé par les deux interrupteurs T3 et T2 est connecté en parallèle de l'ensemble formée par les premier et quatrième interrupteurs T1 et T4. De plus une liaison 10 relie le point commun des premier et quatrième interrupteurs T1 et T4 et le point commun des troisième et deuxième interrupteurs T3 et T2. Le moyen 2 pour détecter la présence d'un courant alternatif, surveille l'apparition d'un courant dans la liaison 10. Le moyen 2 est réalisé de façon semblable à celui décrit au moyen de la figure 1. Le dispositif représenté figure 2 comporte également des moyens de commande 1 des interrupteurs électroniques T1 à T4. Un exemple de réalisation des moyens de commande 1 sera décrit ultérieurement plus en détail au moyen de la figure 3.

Le dispositif représenté figure 2 peut fonctionner comme le dispositif représenté figure 1 afin que le courant circulant dans la charge C soit sensiblement continu. On utilise ici aussi quatre temps de fonctionnement :

- dans un premier temps ① les interrupteurs T1 et T2 sont conducteurs et les interrupteurs T3 et T4 sont non conducteurs Un courant IP circule dans la liaison 10. Sa direction est donnée par la flèche 11 ;
- dans un deuxième temps ② les quatre interrupteurs électroniques T1, T2, T3 et T4 sont tous conducteurs et aucun courant ne circule dans la liaison 10 ;

- dans un troisième temps ③ les interrupteurs électroniques T1 et T2 sont non conducteurs et les interrupteurs électroniques T3 et T4 sont conducteurs. Le courant IP circule alors dans la liaison 10 dans un sens opposé à flèche 11 ;
- le quatrième temps ④ de fonctionnement est identique au deuxième temps de fonctionnement et aucun courant ne circule dans la liaison 10. Ensuite on répète les quatre temps de fonctionnement décrit précédemment tant que la charge C est alimentée par la source de tension continue.

Le mode de fonctionnement à quatre temps décrit précédemment permet ainsi de ne jamais interrompre le courant circulant dans la charge C. En revanche, il est possible de faire fonctionner le dispositif représenté figure 2 de façon à moduler la puissance dissipée par la charge C en remplaçant les deuxième temps ② et quatrième temps ④ par des temps où les quatre interrupteurs T1, T2, T3 et T4 sont tous non conducteurs. Néanmoins pour la suite de la description on ne s'intéressera qu'au mode de fonctionnement à quatre temps assurant qu'un courant sensiblement continu traverse la charge C en permanence.

La figure 3 représente plus en détail le dispositif représenté figure 2. A partir des deux bornes VCC et 0 de la source de tension continue on réalise une source de tension continue secondaire entre une borne VCC 2 et la borne 0. On connecte en série entre la borne VCC et la borne 0 une résistance R1 et une diode Zener DZ1. La cathode de la diode Zener DZ1 est reliée à la résistance R1. Un condensateur C1 est connecté en parallèle de la diode Zener DZ1. Ces trois composants : la résistance R1, la diode Zener DZ1 et le condensateur C1 permettent de réaliser la source de tension continue secondaire au point commun entre la résistance R1 et la diode de Zener DZ1. Ce point commun forme la borne VCC 2. Lorsque l'on applique l'invention dans le domaine aéronautique, il est courant de disposer d'une tension continue de 28 volts qui sera pour l'invention le potentiel de la borne VCC. Le potentiel de la borne VCC 2 sera par exemple égal à 12 volts. On utilise le potentiel de la borne VCC 2 pour alimenter les moyens de commande 1 des interrupteurs électroniques T1 à T4.

Les moyens de commande 1 comportent quatre portes logiques ET 30 à 33 et un compteur binaire 34. Les portes logiques 30 à 33 et le compteur 34 sont alimentés par le potentiel de la borne VCC 2. Leurs alimentations ne sont pas représentées à la figure 3. Les moyens de commande 1 comportent une horloge 35 comprenant la porte logique 30, une résistance R2 et un condensateur C2. La porte logique 30 est par exemple, une porte logique ET à seuil de déclenchement contrôlé. Cette porte logique est connue dans la littérature anglo-saxonne sous le nom de « NAND SCHMITT GATE ». Une première entrée de la porte logique 30 est directement raccordée à la borne VCC 2. Une deuxième entrée de la porte logique 30 est raccordée à la borne 0 par l'intermédiaire du condensateur C2. La deuxième entrée de la porte logique 30 est également raccordée à la sortie de la porte logique 30 par l'intermédiaire de la résistance R2. A la sortie de la porte logique 30 on dispose d'un signal d'horloge H connecté à une borne du compteur 34 adaptée pour recevoir ce signal H. La valeur de la fréquence du signal H est fonction de la valeur de la résistance R2 et de la valeur du condensateur C2. Le compteur 34 s'incrémente, par exemple, sur chaque front montant du signal d'horloge H. Le compteur 34 dispose par exemple de quatre sorties Q1, Q2, Q3 et Q4 sur lesquelles on dispose du résultat du comptage binaire. Le comptage est réalisé sur quatre bits, chacun disponible sur une des sorties Q1 à Q4. Q1 représente le bit de poids faible et Q4 le bit de poids fort.

A la figure 3, seules les deux sorties Q3, Q4 disposant des bits de poids les plus forts et sont représentés. Pour plus de commodité, on assimile le repère de la sortie du compteur au signal disponible sur cette sortie.

Une première entrée de la porte logique 33 reçoit le signal Q3 et une deuxième entrée de la porte logique 33 reçoit le signal Q4 de sorte que en sortie de la porte logique 33 on dispose d'un signal $\overline{Q3.Q4}$ . Les deux entrées de la porte logique 31 reçoivent le signal Q4 de sorte qu'un signal $\overline{Q4}$ est disponible en sortie de la porte logique 31. La porte logique 32 reçoit sur une de ces entrées le signal Q3 et sur l'autre de ces entrées le signal $\overline{Q4}$ . En sortie de la porte logique 32 on dispose d'un signal $\overline{Q3.\overline{Q4}}$ . Le signal $\overline{Q3.\overline{Q4}}$ se propage vers une commande G1 de l'interrupteur électronique T1 par l'intermédiaire d'une résistance R3. Ce même signal se propage également vers une commande G2 de l'interrupteur électronique T2 par l'intermédiaire d'une résistance R4. Le signal $\overline{Q3.Q4}$ se propage vers une commande G3 de l'interrupteur électronique T3 par l'intermédiaire d'une résistance R5. Ce même signal se propage vers une commande G4 de l'interrupteur électronique T4 par l'intermédiaire d'une résistance R6. Les interrupteurs électroniques T1 à T4 sont des transistors à effets de champs. Ils sont respectivement commandés par leurs grilles G1 à G4. Les drains des transistors T1 et T3 sont tous deux raccordés au point de la charge non raccordés à la borne VCC. La source du transistor T1 est raccordée au drain du transistor T4. La source du transistor T4 est raccordée à la borne 0. La source du transistor T3 est raccordée au drain du transistor T2. La source du transistor T2 est raccordée à la borne 0. La liaison 10 est raccordée, d'une part, entre la source du transistor T1 et le drain du transistor T4 et d'autre part, entre la source du transistor T3 et le drain du transistor T2.

L'invention est décrite en rapport avec des transistors à effet de champ. Il est bien entendu qu'on pourrait mettre en oeuvre l'invention avec tout autre type d'interrupteur électronique pour lequel on peut commander à la fois l'ouverture et la fermeture comme par exemple des transistors bipolaires ou des transistors bipolaires à grille isolée connus dans la littérature anglo-saxonne sous le nom de « Insulated Gate Bipolar Transistor (IGBT) ». La liaison 10 se fait au travers de l'enroulement primaire TRP du transformateur du courant TR. L'enroulement secondaire · TRS du transformateur de courant TR est relié aux deux entrées e1 et e2 du redresseur 3.

Le redresseur 3 comporte cinq diode D1, D2, D3, D4 et D5 ainsi qu'un condensateur C5. Le point e1 est raccordé à l'anode de la diode D1 et à la cathode de la diode D3. Le point e2 est raccordé à l'anode de la diode D2 et à la cathode de la diode D4. Le condensateur C5 et la diode D5 sont raccordés entre, d'une part, les cathodes des diodes D1 et D2 toutes deux connectées ensemble et, d'autre part, les anodes des diodes D3 et D4 toutes deux connectées ensemble. L'anode de la diode D5 est raccordée aux anodes des diodes D3 et D4, pour former le point s2. Le point s1 est quant à lui situé à la cathode de la diode D5. Le relais RL est semblable à celui décrit au moyen de la figure 1. Sa bobine B est raccordée entre les points si et s2. Le condensateur C5 permet de lisser la tension continue obtenue entre les points s1 et s2. La diode D5 permet de protéger le condensateur C5, qui peut par exemple être un condensateur chimique, lorsque le courant continu s'arrête et que le bobine B se démagnétise.

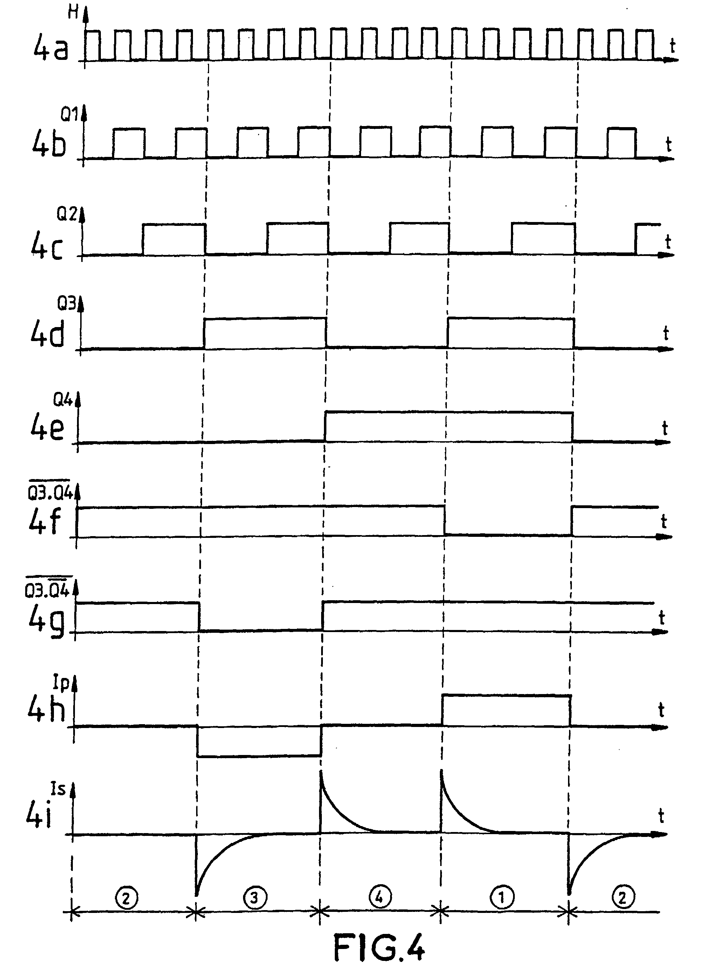

A la figure 4 on a représenté neuf chronogrammes 4a à 4i, évoluant sur la même échelle des temps, afin de mieux expliquer le fonctionnement du dispositif dans un cycle à quatre temps où le courant continu dans la charge circule en permanence. Les chronogrammes 4a à 4g représentent des signaux logiques évoluant entre deux niveaux logiques 0 et 1.

Le chronogramme 4a représente le signal d'horloge H. Le signal H est un signal rectangulaire de fréquence constante.

Le chronogramme 4b représente le signal Q1 disponible sur une première sortie du compteur 34. Le signal Q1 est un signai rectangulaire dont la fréquence est la moitié de la fréquence du signal H. Le signal Q1 change d'état logique en même temps que chaque front montant du signal d'horloge H.

Le chronogramme 4c représente le signal Q2 disponible sur une deuxième sortie du compteur 34. Le signal Q2 est un signal rectangulaire dont la fréquence est la moitié de la fréquence du signal Q1. Le signal Q2 change d'état logique en même temps que chaque front descendant du signal Q1.

Le chronogramme 4d représente le signal Q3 disponible sur une troisième sortie du compteur 34, Le signal Q3 est un signal rectangulaire dont la fréquence est la moitié de la fréquence du signal Q2. Le signal Q3 change d'état logique en même temps que chaque front descendant du signal Q2.

Le chronogramme 4e représente le signal Q4 disponible sur une quatrième sortie du compteur 34. Le signal Q4 est un signal rectangulaire dont la fréquence est la moitié de la fréquence du signal Q3. Le signal Q4 change d'état logique en même temps que chaque front descendant du signal Q3.

Le chronogramme 4f représente le signal $\overline{Q3.Q4}$ disponible à la sortie de la porte logique 33. Le signal $\overline{Q3.Q4}$ vaut 1 sur l'ensemble du chronogramme sauf lorsque les signaux Q3 et Q4 valent simultanément 1. Lorsque cette dernière condition est remplie le signal $\overline{Q3.Q4}$ vaut 0.

Le chronogramme 4g représente le signal $\overline{Q3.\overline{Q4}}$ disponible en sortie de la porte logique 32. Le signal $\overline{Q3.\overline{Q4}}$ vaut 1 sur l'ensemble du chronogramme sauf lorsque Q3 vaut 1 et que Q4 vaut 0 simultanément. Lorsque cette dernière condition est remplie le signal $\overline{Q3.\overline{Q4}}$ vaut 0.

Lorsque le signal $\overline{Q3}.\overline{Q4}$ vaut 1, les interrupteurs électroniques T1 et T2 sont conducteurs. Lorsque le signal $\overline{Q3}.\overline{Q4}$ vaut 0 les interrupteurs électroniques T1 et T2 sont non conducteurs. De la même façon lorsque le signal $\overline{Q3.Q4}$ vaut 1 les interrupteurs électroniques T3 et T4 sont conducteurs. Lorsque le signal $\overline{Q3.Q4}$ vaut 0, les interrupteurs électroniques T3 et T4 sont non conducteurs. Les quatre temps ①, ②, ③ et ④ de fonctionnement du dispositif, décrit précédemment, sont représentés précédemment sous le chronogramme 4i.

Les moyens de commande 1, représentés figure 3, assurent que les quatre temps ①, ②, ③ et ④ de fonctionnement ont sensiblement la même durée. Il est bien entendu que l'invention peut être mise en oeuvre quelle que soit la durée relative des différents temps de fonctionnement. Ceci s'applique également pour les temps de fonctionnement décrits à partir du dispositif représenté figure 1. On note que les deuxième et quatrième temps de fonctionnement ont pour fonction d'éviter que le courant soit interrompu dans la charge C.

Le chronogramme 4h représente la valeur du courant IP circulant dans la liaison 10. Lors du premier temps ① de fonctionnement du dispositif, temps où les interrupteurs électroniques T1 et T2 sont tous deux conducteurs, le courant IP est positif et constant. Le courant IP est égal au courant circulant dans la charge C. Lors du deuxième temps ② de fonctionnement du dispositif, temps ou les quatre interrupteurs électroniques T1 à T4 sont tous conducteurs, le courant IF est nul. lors du troisième temps ③ de fonctionnement du dispositif, temps ou seul les interrupteurs électroniques T3 et T4 sont conducteurs, le courant IP est négatif et constant. Sa valeur est égale à l'opposée de la valeur qu'avait le courant IP durant le premier temps ① de fonctionnement du dispositif. Lors du quatrième temps ④ de fonctionnement du dispositif, temps ou les quatre interrupteurs électroniques T1 à T4 sont tous conducteurs le courant IP est nul. A l'issu du quatrième temps ④ de fonctionnement on répète les quatre temps ①, ②, ③ et ④ de fonctionnement décrit précédemment tant que la charge C est alimentée par la source de tension continue. On rappelle que le courant IP circule également dans l'enroulement primaire TRP du transformateur de courant TR.

L'enroulement secondaire TRS du transformateur de courant est quant à lui est parcouru par le courant IS. Le courant IS est représenté sur le chronogramme 4i. Le sens du courant IS est conventionnellement choisi tel que le courant IS est positif lorsque le courant IP croît. En conséquence au début du premier temps ① de fonctionnement le courant IS croît rapidement puis décroît lentement jusqu'à s'annuler avant la fin du premier temps ① de fonctionnement. Au début du deuxième temps ② de fonctionnement le courant IS décroît rapidement puis croît lentement jusqu'à s'annuler. Le courant IS s'annule avant la fin du deuxième temps ② de fonctionnement. Pour le courant IS le troisième temps ③ de fonctionnement est identique au deuxième temps ② de fonctionnement. Le quatrième temps ④ de fonctionnement est quant à lui identique au premier temps ① de fonctionnement.

Les composants du redresseur 3, notamment le condensateur 5, sont choisis de telle sorte que tant que les quatre temps ①, ②, ③ et ④ décrits précédemment s'enchaînent, un courant sensiblement continu peut circuler dans la bobine B du relais RL et ainsi commander le contact K.

## Revendications

**1.** Procédé de surveillance de la circulation d'un courant sensiblement continu dans une charge (C) **caractérisé en ce qu'**il utilise un dispositif comportant, connecté en série avec la charge (C). des premiers moyens (2) pour détecter la présence d'un courant alternatif (IP), des seconds moyens (TA) pour interrompre le courant circulant dans les premiers moyens (2) ainsi que des troisièmes moyens (TB) susceptibles de court-circuiter les premiers et seconds moyens, et **en ce que** le procédé enchaîne de façon cyclique les temps de fonctionnement suivants tant que la charge est alimentée :

- pendant le premier temps (①) le courant circule uniquement dans les seconds moyens (TA) et premiers moyens (2);
- pendant le deuxième temps (②) le courant circule à la fois dans les seconds moyens et dans les troisièmes moyens ;
- pendant le troisième temps (③) le courant circule uniquement dans les troisièmes moyens;
- le quatrième temps (④) est identique au deuxième temps (②).

**2.** Procédé selon la revendication 1, **caractérisé en ce que** les seconds moyens comportent un premier interrupteur électronique (TA), **en ce que** les troisièmes moyens comportent un second interrupteur électronique (TB) connecté en parallèle d'un ensemble formé par le premier interrupteur électronique (TA) et les premiers moyens (2) pour détecter la présence d'un courant alternatif (IP), et **en ce que** le procédé enchaîne de façon cyclique les temps de fonctionnement suivants tant que la charge est alimentée :

- pendant le premier temps (①) le premier interrupteur électronique (TA) est fermé et le second interrupteur électronique (TB) est ouvert ;
- pendant le deuxième temps (②) les premier et second interrupteurs électroniques (TA, TB) sont tous deux fermés ;
- pendant le troisième temps (③) le premier interrupteur électronique (TA) est ouvert et le second interrupteur électronique (TB) est fermé;
- le quatrième temps (④) est identique au deuxième temps (②).

**3.** Procédé selon la revendication 1, **caractérisé en ce que** les seconds et troisièmes moyens comportent quatre interrupteurs électroniques (T1, T2, T3, T4), **en ce que** le premier interrupteur (T1) et le quatrième interrupteur (T4) sont tous deux connectés en série avec la charge (C), **en ce que** le troisième interrupteur (T3) et le deuxième interrupteur (T2) sont tous deux connectés en série et forment un ensemble connecté en parallèle des premiers (T1) et quatrième (T4) interrupteurs, **en ce que** le point commun des premier (T1) et quatrième (T4) interrupteurs est connecté au point (10) commun des troisième (T3) et deuxième (T2) interrupteurs, et **en ce que** les premiers moyens (2) pour détecter la présence d'un courant alternatif (IP) surveillent le courant circulant entre les deux points communs, et **en ce que** le procédé enchaîne de façon cyclique les temps de fonctionnement suivants tant que la charge est alimentée :

- pendant le premier temps (①) les premier (T1) et deuxième (T2) interrupteurs électroniques sont conducteurs et les troisième (T3) et quatrième (T4) interrupteurs électroniques sont non conducteurs ;
- pendant le deuxième temps (②) les quatre interrupteurs électroniques (T1, T2, T3, T4) sont conducteurs ;
- pendant le troisième temps (③) les premier (T1) et deuxième (T2) interrupteurs électroniques sont non conducteurs et les troisième (T3) et quatrième (T4) interrupteurs électroniques sont conducteurs ;
- pendant le quatrième temps (④) les quatre interrupteurs électroniques (T1, T2, T3, T4) sont conducteurs.

**4.** Procédé selon l'une des revendications précédentes, **caractérisé en ce que** les premiers moyens (2) pour détecter la présence du courant alternatif comportent un transformateur de courant (TR) dont l'enroulement primaire (TRP) est parcouru par le courant alternatif (IP) et dont l'enroulement secondaire (TRS) délivre une information représentative de la circulation du courant dans la charge (C).

5. Procédé selon la revendication 4, **caractérisé en ce que** l'information est un second courant alternatif (IS), **en ce que** le dispositif comporte en outre un redresseur (3), **en ce que** les entrées (e1, e2) du redresseur (3) sont reliées à l'enroulement secondaire (TRS) et **en ce que** la présence d'un courant circulant entre les sorties (s1, s2) du redresseur (3) commande une position active d'un relais monostable (RL).

6. Procédé selon l'une quelconque des revendications 2 à 5, **caractérisé en ce que** l'interrupteur électronique (TA, TB ; T1, T2, T3, T4) est un transistor à effet de champ.

**Patentansprüche**

1. Verfahren zur Überwachung des Fließens eines im wesentlichen gleichförmigen Stroms durch eine Last (C), **dadurch gekennzeichnet, daß** es eine Vorrichtung verwendet, die in Reihe mit der Last (C) erste Mittel (2) zur Erfassung des Vorliegens eines Wechselstroms (IP), zweite Mittel (TA) zur Unterbrechung des in den ersten Mitteln (2) fließenden Stroms, sowie dritte Mittel (TB) enthält, die die ersten und zweiten Mittel kurzschließen können, und daß das Verfahren zyklisch folgende Betriebsphasen ablaufen läßt, so lange die Last mit Strom gespeist wird:

- während der ersten Phase (①) fließt der Strom nur in den ersten Mitteln (2) und den zweiten Mitteln (TA);
- während der zweiten Phase (②) fließt der Strom sowohl in den zweiten als auch in den dritten Mitteln;
- während der dritten Phase (③) fließt der Strom nur in den dritten Mitteln;
- die vierte Phase (④) gleicht der zweiten Phase (②).

2. Verfahren nach Anspruch 1, **dadurch gekennzeichnet, daß** die zweiten Mittel einen ersten elektronischen Unterbrecher (TA) aufweisen, daß die dritten Mittel einen zweiten elektronischen Unterbrecher (TB) aufweisen, der zu einer von dem ersten elektronischen Unterbrecher (TA) und den ersten Mitteln (2) zur Erfassung des Vorliegens eines Wechselstroms (IP) gebildeten Schaltung parallel geschaltet ist, und daß das Verfahren zyklisch die folgenden Betriebsphasen durchläuft, so lange die Last mit Strom gespeist wird:

- während der ersten Phase (①) ist der erste elektronische Schalter (TA) geschlossen und der zweite elektronischen Schalter (TB) offen;
- während der zweiten Phase (②) sind der erste elektronische Unterbrecher (TA) und der zweite elektronische Unterbrecher (TB) beide geschlossen;
- während der dritten Phase (③) ist der erste elektronische Unterbrecher (TA) offen und der zweite elektronische Unterbrecher (TB) geschlossen;
- die vierte Phase (④) gleicht der zweiten Phase (②).

3. Verfahren nach Anspruch 1, **dadurch gekennzeichnet, daß** die zweiten und dritten Mittel vier elektronische Unterbrecher (T1, T2, T3, T4) aufweisen, daß der erste Unterbrecher (T1) und der vierte Unterbrecher (T4) beide mit der Last (C) in Reihe geschaltet sind, daß der dritte Unterbrecher (T3) und der zweite Unterbrecher (T2) miteinander in Reihe und gemeinsam zum ersten Unterbrecher (T1) und zum vierten Unterbrecher (T4) parallelgeschaltet sind, daß der Verbindungspunkt zwischen dem ersten und dem vierten Unterbrecher (T1, T4) mit dem gemeinsamen Punkt (10) des dritten Unterbrechers (T3) und des zweiten Unterbrechers (T2) verbunden ist und daß die ersten Mittel (2) zur Erfassung des Vorliegens eines Wechselstroms (IP) den zwischen den beiden gemeinsamen Punkten fließenden Strom überwacht und daß das Verfahren zyklisch die folgenden Betriebsphasen durchläuft, so lange die Last mit Strom gespeist wird:

- während der ersten Phase (①) sind der erste und der zweite elektronische Unterbrecher (T1, T2) leitend, während der dritte und der vierte elektronische Unterbrecher (T3, T4) nicht leitend sind;
- während der zweiten Phase (②) sind alle vier elektronischen Unterbrecher (T1, T2, T3, T4) leitend;
- während der dritten Phase (③) sind der erste und der zweite elektronische Unterbrecher (T1, T2) nicht leitend, während der dritte und der vierte elektronische Unterbrecher (T3, T4) leitend sind;
- während der vierten Phase (④) sind alle vier elektronischen Unterbrecher (T1, T2,, T3, T4) leitend.

4. Verfahren nach einem der vorstehenden Ansprüche, **dadurch gekennzeichnet, daß** die ersten Mittel (2) zur Erfassung des Vorliegens des Wechselstroms einen Stromtransformator (TR) enthalten, dessen Primärwicklung (TRP) von dem Wechselstrom (IP) durchflossen wird und dessen Sekundärwicklung (TRS) eine Information liefert, die für das Fließen des Stroms in der Last (C) repräsentativ ist.

5. Verfahren nach Anspruch 4, **dadurch gekennzeichnet, daß** die Information ein zweiter Wechselstrom (IS) ist, daß die Vorrichtung außerdem einen Gleichrichter (3) enthält, daß die Eingänge (e1, e2) des Gleichrichters an die Sekundärwicklung (TRS) angeschlossen sind und daß das Vorliegen eines Stroms zwischen den Ausgängen (s1, s2) des Gleichrichters (3) ein monostabiles Relais (RL) in seine erregte Stellung steuert.

6. Verfahren nach einem beliebigen der Ansprüche 2 bis 5, **dadurch gekennzeichnet, daß** die elektronischen Unterbrecher (TA, TB; T1, T2, T3, T4) Feldeffekttransistoren sind.

## Claims

1. Method for monitoring a substantially direct current flow in a load (C), **characterized in that** it uses a device comprising, connected in series with the load (C), first means (2) for detecting the presence of an alternating current (IP), second means (TA) for interrupting the current flowing in the first means (2) as well as third means (TB) capable of short-circuiting the first and second means, and **in that** the method gives rise, cyclically, to the following operating stages so long as the load is powered:

   - during the first stage (①), the current flows only in the second means (TA) and first means (2);
   - during the second stage (②), the current flows both in the second means and in the third means;
   - during the third stage (③), the current flows only in the third means;
   - the fourth stage (④) is identical to the second stage (②).

2. Method according to Claim 1, **characterized in that** the second means comprise a first electronic switch (TA), **in that** the third means comprise a second electronic switch (TB) connected in parallel to an assembly formed by the first electronic switch (TA) and the first means (2) for detecting the presence of an alternating current (IP), and **in that** the method gives rise, cyclically, to the following operating stages so long as the load is powered:

   - during the first stage (①), the first electronic switch (TA) is closed and the second electronic switch (TB) is open;
   - during the second stage (②), the first and second electronic switches (TA, TB) are both closed;
   - during the third stage (③), the first electronic switch (TA) is open and the second electronic switch (TB) is closed;
   - the fourth stage (④) is identical to the second stage (②).

3. Method according to Claim 1, **characterized in that** the second and third means comprise four electronic switches (T1, T2, T3, T4), **in that** the first switch (T1) and the fourth switch (T4) are both connected in series with the load (C), **in that** the third switch (T3) and the second switch (T2) are both connected in series and form an assembly connected in parallel with the first (T1) and fourth (T4) switches, **in that** the common point of the first (T1) and fourth (T4) switches is connected to the common point (10) of the third (T3) and second (T2) switches, and **in that** the first means (2) for detecting the presence of an alternating current (IP) monitor the current flowing between the two common points, and **in that** the method gives rise, cyclically, to the following operating stages so long as the load is powered:

   - during the first stage (①), the first electronic switch (T1) and second electronic switch (T2) are conducting and the third electronic switch (T3) and fourth electronic switch (T4) are not conducting;
   - during the second stage (②), all four electronic switches (T1, T2, T3, T4) are conducting;
   - during the third stage (③), the first electronic switch (T1) and second electronic switch (T2) are not conducting and the third electronic switch (T3) and fourth electronic switch (T4) are conducting;
   - during the fourth stage (④), all four electronic switches (T1, T2, T3, T4) are conducting.

4. Method according to one of the preceding claims, **characterized in that** the first means (2) for detecting the presence of the alternating current comprise a current transformer (TR) in which the alternating current (IP) passes through the primary winding (TRP) and in which the secondary winding (TRS) delivers a piece of information representing the flow of the current in the load (C).

5. Method according to Claim 4, **characterized in that** the piece of information is a second alternating current (IS), **in that** the device furthermore has a rectifier (3), **in that** the inputs (e1, e2) of the rectifier (3) are connected to the secondary winding (TRS) and **in that** the presence of a current flowing between the outputs (s1, s2) of the rectifier (3) controls an active position of a monostable relay (RL).

6. Method according to any one of Claims 2 to 5, **characterized in that** the electronic switch (TA, TB; T1, T2, T3, T4) is a field-effect transistor.

FIG.1

EP 1 166 134 B1

FIG.2

FIG.3

EP 1 166 134 B1

FIG.4